# EUROPEAN PATENT APPLICATION

(11) **EP 2 899 588 A1**
(43) Date of publication of application: **29.07.2015**
(21) Application number: 13838335.1
(22) Date of filing: 13.09.2013
(51) Int. Cl.: G02F 1/1343, G02F 1/1368

(54) **LIQUID CRYSTAL DISPLAY**

(30) Priority: 21.09.2012 JP 2012208687
(71) Applicant: Sharp Kabushiki Kaisha, Osaka-shi, Osaka 545-8522 (JP)
(72) Inventor: TAKANISHI, Yudai, Osaka-shi, Osaka 545-8522 (JP); KIKUCHI, Tetsuo, Osaka-shi, Osaka 545-8522 (JP); HARA, Yoshihito, Osaka-shi, Osaka 545-8522 (JP)
(74) Representative: Müller-Boré & Partner Patentanwälte PartG mbB
(86) International application number: PCT/JP2013/074804
(87) International publication number: WO 2014/046025

(57) **Abstract**

The present invention provides a liquid crystal display capable of enhancing moisture resistance and resist applicability while suppressing alignment disorder of liquid crystal molecules. The present invention relates to a liquid crystal display including: an organic insulating film; a transparent electrode arranged on the organic insulating film; and an interlayer insulating film arranged on the transparent electrode, the transparent electrode including a plasma-treated surface, the organic insulating film being shaved vertically from an end portion of the transparent electrode, and thereby including a step portion under the end portion, the transparent electrode not laterally protruding from the step portion, the step portion having a height of 20 nm or lower.

## Description

### TECHNICAL FIELD

The present invention relates to a liquid crystal display. More specifically, the present invention relates to a liquid crystal display suitable for a fringe field switching (FFS) mode, which is one of horizontal alignment modes.

### BACKGROUND ART

Liquid crystal displays commonly include a thin film transistor substrate (hereinafter, also referred to as an array substrate) on which pixel electrodes and thin-film transistors (TFTs) are formed in a matrix; a counter substrate that faces the array substrate and includes color filters arranged to correspond to the pixel electrodes; and a liquid crystal layer sandwiched between the array substrate and the counter substrate. Liquid crystal displays control the alignment of liquid crystal molecules in the liquid crystal layer to control the transmittance of light for each pixel, thereby producing an image.

Since liquid crystal displays are flat and lightweight, they can be used in various fields from large-sized display devices (e.g. TVs) to cellphones and digital still cameras (DSCs). Liquid crystal displays, however, sometimes have problems in the viewing angle properties. Poor viewing angle properties change the luminance and/or the chromaticity in the front view and oblique views of the display.

The known major liquid crystal modes for liquid crystal displays are a vertical alignment (VA) mode which controls the alignment of liquid crystal molecules by applying an electric field in the direction perpendicular to the substrate surfaces to liquid crystal molecules having a negative anisotropy of dielectric constant; and a horizontal alignment mode which controls the alignment of liquid crystal molecules by applying an electric field in the direction horizontal (parallel) to the substrate surfaces (i.e. transverse electric field) to liquid crystal molecules having a positive or negative anisotropy of dielectric constant. In terms of the viewing angle, the horizontal alignment mode is generally considered to be better than the vertical alignment mode. One of the horizontal alignment-mode liquid crystal displays suggested is a fringe field switching (FFS)-mode liquid crystal display. FFS-mode liquid crystal displays provide display by applying a fringe electric field (oblique electric field including both the transverse electric field components and vertical electric field components) to the liquid crystal layer.

As to the FFS-mode liquid crystal displays, Patent Literature 1, for example, discloses a technology for forming an overhanging portion by shaving the surface of an organic passivation film by plasma-asher treatment before formation of an interlayer insulating film on the counter substrate formed on the organic passivation film.

### CITATION LIST

### - Patent Literature

Patent Literature 1: JP 2012-53371 A

### SUMMARY OF INVENTION

### - Technical Problem

In an FFS-mode liquid crystal display, the adhesion between the counter electrode and the interlayer insulating film formed on the counter electrode may decrease to cause the interlayer insulating film to peel. This problem occurs probably because of the following two factors. One of the factors is that the film forming temperature for an interlayer insulating film cannot be raised because the interlayer insulating film needs to be formed on the organic insulating film, and thus the interlayer insulating film is formed at low temperatures. The other factor is the resist residues on the counter electrode. The above-described factors are regarded as bringing difficulties in providing cohesion between the counter electrode and the interlayer insulating film.

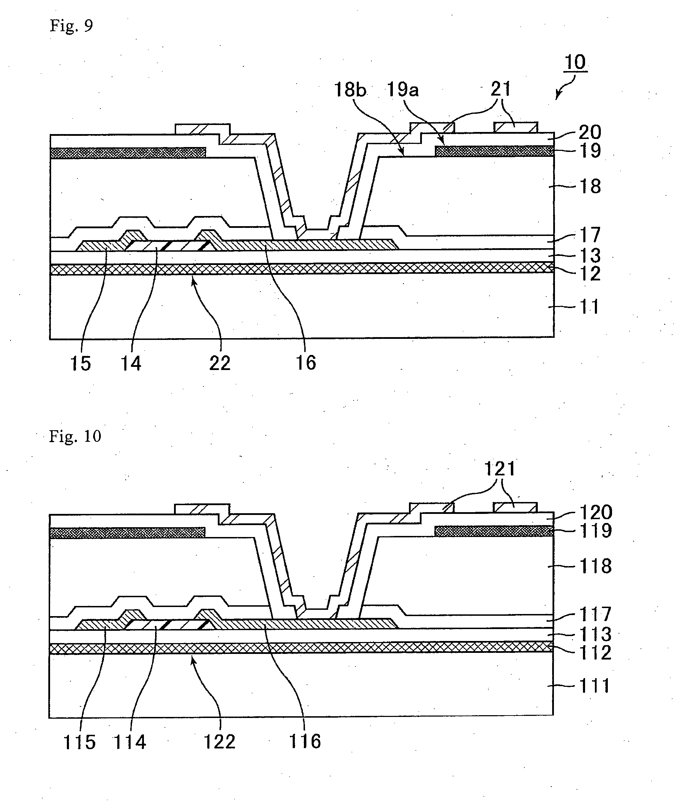

Fig. 10 is a schematic cross-sectional view of an array substrate in Comparative Embodiment 1, illustrating a TFT and the neighboring regions thereof in a display region, on which the present inventors have made studies.

The array substrate of Comparative Embodiment 1 is an array substrate for FFS-mode liquid crystal displays. As illustrated in Fig. 10, the array substrate is provided with an insulating substrate 111, TFTs 122 arranged on the insulating substrate 111, a first interlayer insulating film 117 arranged on the TFTs 122, an organic insulating film 118 arranged on the first interlayer insulating film 117, a counter electrode 119 arranged on the organic insulating film 118, a second interlayer insulating film 120 covering the organic insulating film 118 and the counter electrode 119, and pixel electrodes 121 arranged on the second insulating film 120. The TFTs 122 each include a gate electrode 112, a gate insulating film 113, a semiconductor layer 114, a source electrode 115, and a drain electrode 116.

The organic insulating film 118 is arranged to reduce the irregularities on the surface of the array substrate. In the case of forming the second interlayer insulating film 120 by plasma-enhanced chemical vapor deposition (CVD), a higher film formation temperature gives higher adhesion to the base film. The film formation temperature, however, needs to be low in order to suppress changes in the properties of the organic insulating film 118. Specifically, the film formation temperature is preferably 220°C or lower. Here, the second interlayer insulating film 120 formed at low temperatures unfortunately has poor adhesion to the base film, and may peel off the base film as described above.

Patent Literature 1 deals with the problem by a technology of enhancing the adhesion between the counter electrode and the interlayer insulating film by performing plasma-asher treatment before formation of the interlayer insulating film so as to shave the surface of the organic passivation film and also roughen the counter electrode surface, and removing the resist residues on the counter electrode.

With the technology described in Patent Literature 1, however, the plasma-asher treatment greatly shaves the organic passivation film, and the counter electrode on the organic passivation film overhangs on the organic passivation film. Therefore, the film coatability of the interlayer insulating film arranged on the counter electrode deteriorates in the vicinity of an end portion of the counter electrode, causing defects. Specifically, the moisture resistance of the interlayer insulating film may decrease or the alignment disorder of the liquid crystal molecules may occur. Also, the deterioration in the coatability may decrease the resist applicability of the film during photolithography for forming openings in the interlayer insulating film. As a result, application defects such as cissing may occur when a resist material is applied to the interlayer insulating film.

The present invention has been made in view of the above current state of the art, and aims to provide a liquid crystal display capable of enhancing moisture resistance and resist applicability while suppressing alignment disorder of liquid crystal molecules.

### - Solution to Problem

One aspect of the present invention may be a liquid crystal display including:
an organic insulating film;
a transparent electrode arranged on the organic insulating film; and
an interlayer insulating film arranged on the transparent electrode,
the transparent electrode including a plasma-treated surface,
the organic insulating film being shaved vertically from an end portion of the transparent electrode, and thereby including a step portion under the end portion,
the transparent electrode not laterally protruding from the step portion,
the step portion having a height of 20 nm or lower.

Hereinafter, such a liquid crystal display is also referred to as a first liquid crystal display of the present invention.

Another aspect of the present invention may be a liquid crystal display including:
an organic insulating film;
a transparent electrode arranged on the organic insulating film; and
an interlayer insulation film arranged on the transparent electrode,
the transparent electrode including a plasma-treated surface,
the organic insulating film including a flat upper surface without a step portion under an end portion of the transparent electrode.

Hereinafter, such a liquid crystal display is also referred to as a second liquid crystal display of the present invention.

The preferred embodiments of the first and second liquid crystal displays of the present invention are described below. The following preferred embodiments may be appropriately combined with one another, and an embodiment obtained by combining at least two of the following preferred embodiments is also one preferred embodiment.

The step portion may have a height lower than 10 nm.

The transparent electrode may be a counter electrode or a pixel electrode.

The first and second liquid crystal displays of the present invention may each further include a TFT including an oxide semiconductor under the organic insulating film.

The oxide semiconductor may contain indium, gallium, zinc, and oxygen.

### - Advantageous Effects of Invention

The present invention can provide a liquid crystal display capable of enhancing moisture resistance and resist applicability while suppressing alignment disorder of liquid crystal molecules.

### BRIEF DESCRIPTION OF DRAWINGS

Fig. 1 is a schematic cross-sectional view of a liquid crystal display of Embodiment 1, illustrating a TFT in a display region and the neighboring regions thereof.
Fig. 2 is an enlarged view of the vicinity of an end portion of a counter substrate in Fig. 1.
Fig. 3 is a process flow chart of an array substrate included in the liquid crystal display of Embodiment 1.
Fig. 4 is an SEM photograph of a cross-section of the array substrate of Embodiment 1 before formation of a counter electrode.
Fig. 5 is another SEM photograph of a cross-section of the array substrate of Embodiment 1 before formation of a counter electrode.
Fig. 6 is an SEM photograph of a cross-section of an array substrate of Comparative Embodiment 2 before formation of a counter electrode.
Fig. 7 is an SEM photograph of a cross-section of an array substrate of Comparative Embodiment 3 before formation of a counter electrode.
Fig. 8 is an SEM photograph of a cross-section of an array substrate of Comparative Embodiment 4 before formation of a counter electrode.
Fig. 9 is a schematic cross-sectional view of an array substrate included in the liquid crystal display of Embodiment 2, illustrating a TFT and the neighboring regions thereof in a display region.
Fig. 10 is a schematic cross-sectional view of an array substrate of Comparative Embodiment 1, illustrating a TFT and the neighboring regions thereof in a display region.

### DESCRIPTION OF EMBODIMENTS

The present invention will be described in more detail below with reference to the drawings based on embodiments which, however, are not intended to limit the scope of the present invention.

The end portion of a counter electrode herein means a portion at which the counter electrode ends. The end portion of a counter electrode therefore may be a portion adjacent to an opening formed in the counter electrode or a portion (peripheral portion) adjacent to the periphery of the counter electrode, for example.

### (Embodiment 1)

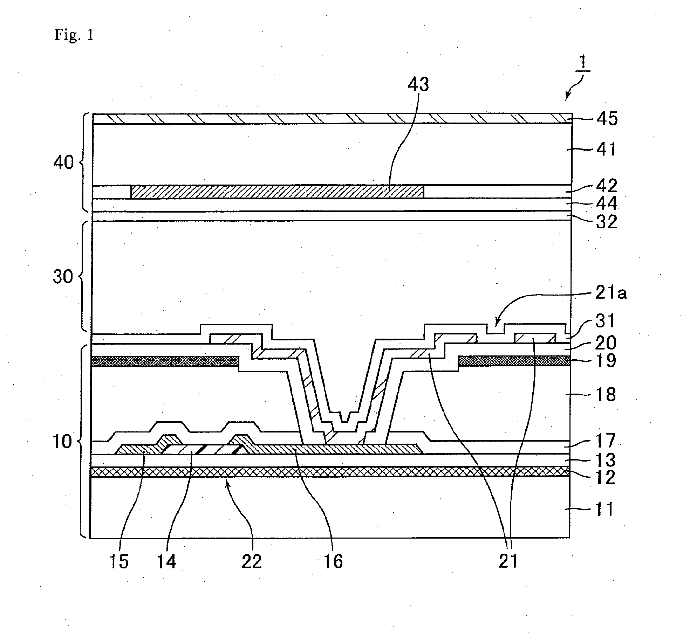

Fig. 1 is a schematic cross-sectional view of a liquid crystal display of Embodiment 1, illustrating a TFT and the neighboring regions thereof in a display region.

The liquid crystal display of the present embodiment is an active-matrix driven, transparent, FFS-mode (one of horizontal alignment modes) liquid crystal display. As illustrated in Fig. 1, the liquid crystal display of the present embodiment is provided with a liquid crystal panel 1, a backlight (not illustrated) arranged on the rear side of the liquid crystal panel 1, a controller (not illustrated) configured to drive and control the liquid crystal panel 1 and the backlight, and a flexible substrate (not illustrated) connecting the liquid crystal panel 1 to the controller.

The liquid crystal panel 1 includes a display region for display of images. The display region includes pixels arranged in a matrix. Each pixel may include subpixels in multiple colors (e.g. three colors: red, green, and blue). The liquid crystal display of the present embodiment may be a black and white liquid crystal display, and in this case, it is not necessary to divide each pixel into multiple subpixels.

The liquid crystal panel 1 includes an array substrate (active matrix substrate) 10, a counter substrate 40 which faces the array substrate 10, a liquid crystal layer 30 and a seal (not shown) arranged between the substrates 10 and 40, an alignment film 31 arranged on the liquid crystal layer 30 side surface of the array substrate 10, an alignment film 32 arranged on the liquid crystal layer 30 side surface of the counter substrate 40, a source driver (not illustrated) which is a driving circuit for the later-described source bus lines, and a gate driver (not illustrated) which is a driving circuit for the later-described gate bus lines. The alignment films 31 and 32 define the initial alignment of liquid crystal molecules (not illustrated) in the liquid crystal layer 30.

The seal is formed to surround the display region. The seal bonds the substrates 10 and 40 to one another, and encloses the liquid crystal layer 30 between the substrates 10 and 40.

The array substrate 10 is arranged on the rear side of the liquid crystal display, while the counter substrate 40 is arranged on the viewer side. The array substrate 10 is irradiated with light from the backlight, and an image displayed on the liquid crystal panel 1 is viewed from the counter substrate 40 side. To the surface on the side opposite to the liquid crystal layer 30 side of each of the substrates 10 and 40, a polarizing plate (not illustrated) is attached. These polarizing plates are usually arranged in crossed Nicols.

The counter substrate 40 includes a transparent insulating substrate 41, color filters 42 in multiple colors, a black matrix (BM) 43 configured to function as a light-shielding member, an overcoat film 44 covering the color filters 42 and the BM 43, multiple pillar-shaped spacers (not illustrated), and an external conductive film 45 arranged on the surface opposite to the liquid crystal layer 30 side surface of the counter substrate 40. The BM 43 is formed to shield from light the regions (frame regions) surrounding the display region, the regions facing the bus lines, and the regions facing the later-described TFTs. The color filters 42 in the respective colors are arranged in the display region, and are formed to cover the regions defined by the BM 43, i.e., the openings of the BM 43. The overcoat film 44 is formed to reduce irregularities on the surface (flatter the surface) of the counter substrate 40. The pillar-shaped spacers are components arranged to keep a given space between the array substrate 10 and the counter substrate 40, and are arranged within the light-shielding region on the BM 43. The external conductive film 45 is arranged to stabilize the electric field inside the liquid crystal panel 1, and is formed from a transparent conductive film material such as indium tin oxide (ITO) by sputtering, for example.

The array substrate 10 includes a transparent insulating substrate 11, and various components formed on the insulating substrate 11. Specifically, the array substrate 10 includes the source bus lines and gate bus lines (neither of which is illustrated) arranged to cross one another, in the display region. Multiple common bus lines may be formed in parallel with the gate bus lines. The subpixels almost conform to the respective regions defined by the source bus lines and the gate bus lines or common bus lines.

The array substrate 10 includes multiple TFTs 22 configured to function as switching elements in the display region. On the insulating substrate 11, a gate electrode 12 is formed, and a gate insulating film 13 is arranged to cover the gate electrode 12. On the gate insulating film 13, a semiconductor layer 14 is formed to overlap the gate electrode 12. The semiconductor layer 14 has an island shape. On the gate insulating film 13, a source electrode 15 and a drain electrode 16 are formed to partially overlap the semiconductor layer 14. On the gate insulating film 13, the semiconductor layer 14, the source electrode 15, and the drain electrode 16, a first interlayer insulating film 17 is provided. On the first interlayer insulating film 17, an organic insulating film 18 is provided. On the organic insulating film 18, a transparent counter electrode 19 corresponding to the transparent electrode is provided. On the counter electrode 19, a second interlayer insulating film 20 is arranged to cover the organic insulating film 18 and the counter electrode 19. On the second interlayer insulating film 20, transparent pixel electrodes 21 connected to the respective TFTs 22 are arranged. The TFTs 22 and the pixel electrodes 21 are formed in regions corresponding to the respective subpixels. Each of the TFTs 22 is connected to the corresponding source bus line and gate bus line.

Each of the TFTs 22 has a bottom gate structure, and formed from the gate electrode 12, the gate insulating film 13, the semiconductor layer 14, the source electrode 15, and the drain electrode 16. The gate electrode 12 is connected to a gate bus line, and the source electrode 15 is connected to the source bus line. The source electrode 15 and the drain electrode 16 are each connected to the semiconductor layer 14.

On the drain electrode 16, the first interlayer insulating film 17, the organic insulating film 18, and the second interlayer insulating film 20 each have an opening, and the pixel electrode 21 is connected to the drain electrode 16 through these openings. On each of the pixel electrodes 21, multiple slits (elongated openings) 21a parallel to one another are formed. The counter electrode 19 is formed to face at least the slits 21a in the region excluding the openings. The counter electrode 19 may be formed to cover the entire display region in the regions excluding the openings.

To the gate bus lines and the gate electrode 12, pulse scanning signals are supplied at certain timings from the gate driver, and the scanning signals are line-sequentially applied to the respective TFTs 22. The TFTs 22 are each turned on for a given period of time upon input of a scanning signal. While the TFTs 22 are turned on, image signals are supplied to the pixel electrodes 21 from the source driver through the source bus lines and the TFTs 22. To the counter electrode 19, a common signal is supplied which is a signal applied commonly to all the pixels. Therefore, when an image signal is applied to one of the pixel electrodes 21, a parabolic electric line of force will be generated between the pixel electrode 21 and the counter electrode 19, which produces a fringe electric field corresponding to the image signal in the liquid crystal layer 30. The fringe electric field controls the alignment (rotation) of liquid crystal molecules (typically, nematic liquid crystal molecules with a positive anisotropy of dielectric constant), whereby the light transmittance of each subpixel is controlled. In this manner, a large number of subpixels are each independently driven, so that an image is displayed in the display region.

The pixel electrodes 21 are placed on the counter electrode 19, with the second interlayer insulating film 20 in between. To the counter electrode 19, common signals are applied as described above. Therefore, when an image signal is applied to the pixel electrodes 21, these transparent components form retention capacitance. In this manner, the pixel electrodes 21 and the counter electrode 19 are also configured to function as electrodes for retention capacitance. The second interlayer insulating film 20 is also configured to function as an insulator that provides insulation between the pixel electrodes 21 and the counter electrode 19, and to function also as a dielectric body that forms retention capacitance.

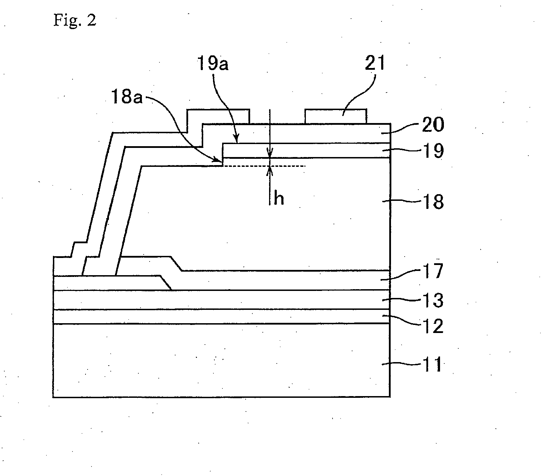

Fig. 2 is an enlarged view of the vicinity of an end portion of the counter electrode illustrated in Fig. 1.

As described later, plasma treatment is performed before formation of the second interlayer insulating film 20 in the present embodiment. Therefore, the counter electrode 19 has a plasma-treated surface. Also, the plasma treatment slightly etches a part of the organic insulating film 18. As a result, as illustrated in Fig. 2, the organic insulating film 18 will be perpendicularly shaved from an end portion 19a of the counter electrode 19, and thus has a step portion 18a under the end portion 19a. The counter electrode 19, however, does not protrude laterally from the step portion 18a, and therefore an overhanging portion is not formed. The height h of the step portion 18a, i.e., the amount of the organic insulating film 18 shaved perpendicularly, is set to 20 nm or lower. Here, the expression "perpendicularly" means the normal direction from the main surfaces of the insulating substrate 11.

With such a structure, it is possible to achieve adhesion of the second interlayer insulating film 20 by the plasma treatment, and also achieve the coatability of the second interlayer insulating film 20 in the vicinity of the end portion 19a and the step portion 18a. The second interlayer insulating film 20, functioning as a dielectric body for retention capacitance as described above, also functions to block moisture. Hence, if the coatability of the film in the vicinity of the step portion 18 deteriorates, moisture may enter the organic insulating film 18 from the step portion 18a to swell the organic insulating film 18, deteriorating the properties of the organic insulating film 18. Moisture in this case from the step portion 18a may reach the TFTs 22 to deteriorate the properties of the TFTs 22. The present embodiment can suppress generation of such defects.

Since the second interlayer insulating film 20 has sufficient coatability, the resist applicability of the second interlayer insulating film 20 can be prevented from decreasing. Therefore, generation of application defects such as cissing can be suppressed when the resist material is applied to the second interlayer insulating film 20.

The above structure can suppress generation of alignment disorder of the liquid crystal molecules in the vicinity of the end portion 19a and the step portion 18a.

Here, the height h of the step portion 18a may be lower than 10 nm. The lower limit for the height h is not particularly limited, and may be appropriately set. The height h may be, for example, 1 nm or higher.

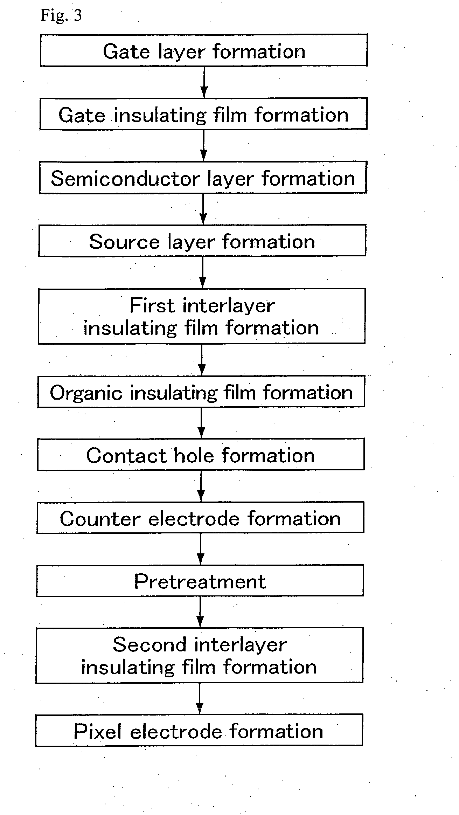

Hereinafter, the method for producing a liquid crystal display of the present embodiment is described. Fig. 3 is a process flow chart of an array substrate included in the liquid crystal display of Embodiment 1.

First, the insulating substrate 11 having an insulating surface is prepared. The insulating substrate 11 can be any insulating substrate commonly used for displays, such as a glass substrate, a silicon substrate, and a heat-resistant plastic substrate. Examples of the material of the plastic substrate include polyethylene terephthalate resin, polyethylenenaphthalate resin, polyether sulfone resin, acrylic resin, and polyimide resin.

Next, a conductive layer (hereinafter, also referred to as a gate layer) including components such as the gate electrodes 12 and gate bus lines is formed on the insulating substrate 11. The material of the gate layer can be, for example, molybdenum (Mo) or aluminum (Al). Also, the gate layer may include a barrier metal layer, the material of which can be, for example, titanium (Ti) or molybdenum (Mo). The gate layer is formed by sputtering, and patterned by wet etching or dry etching through a resist pattern formed thereon by photolithography.

Next, the gate insulating film 13 is formed on the insulating substrate 11 on which the gate layer is formed. The material of the gate insulating film 13 can be, for example, silicon nitride (SiNx) or silicon oxide (e.g. SiO₂). The gate insulating film 13 is formed by plasma CVD or sputtering. The gate insulating film 13 may be a laminate formed from the above materials.

Next, the island-shaped semiconductor layers 14 are formed on the gate insulating film 13. The material of the semiconductor layers 14 can be, for example, amorphous silicon (a-Si), polysilicon (poly-Si), or an oxide semiconductor. The semiconductor layers 14 are formed by plasma CVD or sputtering, and are patterned by wet etching or dry etching through a resist pattern formed by photolithography.

The oxide semiconductor preferably contains oxygen (O) and at least one element selected from the group consisting of indium (In), gallium (Ga), aluminum (Al), copper (Cu), zinc (Zn), magnesium (Mg), and cadmium (Cd), and more preferably contains indium (In), gallium (Ga), zinc (Zn), and oxygen (O). The mobility of the TFTs 22 in the case of using an oxide semiconductor can be made higher than that in the case of using amorphous silicon. Therefore, even when the definition is increased, that is, even when the turned-on time of the TFT 22 per subpixel is shortened, the voltage can be sufficiently applied to the liquid crystal layer 30. Also, when an oxide semiconductor is used, leakage current with the TFTs 22 turned off can be reduced compared to the case of using amorphous silicon. Driving modes, such as low frequency driving and driving with stop periods, can therefore be employed regardless of whether the definition is high or not, and thereby the power consumption can be reduced.

Next, on the insulating substrate 11 on which the semiconductor layers 14 are formed, a conductive layer (hereinafter, also referred to as a source layer) including the source electrodes 15, the drain electrodes 16, and the source bus lines is formed. The material of the source layer can be, for example, molybdenum (Mo) or aluminum (Al). Also, the source layer may include a barrier metal layer, the material of which can be, for example, titanium (Ti) or molybdenum (Mo). The source layer is formed by sputtering, and patterned by wet etching or dry etching through a resist pattern formed thereon by photolithography.

Next, the first interlayer insulating film 17 as an inorganic passivation film is formed on the insulating substrate 11 on which the source layer is formed. The first interlayer insulating film 17 protects TFTs 22, especially channels of the TFTs 22, from impurities. The material of the first interlayer insulating film 17 can be, for example, silicon nitride (SiNx) or silicon oxide (e.g. SiO₂). The first interlayer insulating film 17 is formed by plasma CVD or sputtering. The first interlayer insulating film 17 may be a laminate formed from the above materials.

Next, the organic insulating film 18 is formed on the first interlayer insulating film 17. Openings for connecting the pixel electrodes 21 to the drain electrodes 16 are formed in the organic insulating film 18. The organic insulating film 18 is formed to protect the TFTs 22 and reduce irregularities on the surface (flatter the surface) of the counter substrate 40. The thickness of the organic insulating film 18 is preferably 1 µm to 4 µm, and more preferably 2 µm to 3 µm. The material of the organic insulating film 18 can be a photosensitive resin such as an acrylic photosensitive resin, a silicon-based photosensitive resin, and a polyimide-based photosensitive resin. In the case of using a photosensitive resin material, exposure and development of the photosensitive resin film, i.e. patterning of the film, can be performed without forming a resist pattern. After the patterning, the patterned film is fired by annealing. The annealing provides a smooth, curved surface to the organic insulating film 18 at portions around the openings. The annealing is preferably performed at 190°C to 230°C, more preferably at 200°C to 220°C, for preferably 30 minutes to 2 hours, more preferably about 1 hour.

Then, the first interlayer insulating film 17 is etched by dry etching with the organic insulating film 18 as a mask, so that the surfaces of the drain electrodes 16 are exposed. As a result, contact holes penetrating the organic insulating film 18 and the first interlayer insulating film 17 are formed.

Next, the counter electrode 19 is formed on the organic insulating film 18. The counter electrode 19 is formed on the flat upper surface of the organic insulating film 18. The material of the counter electrode 19 can be, for example, a transparent conductive film material. Specific examples of the transparent conductive film material include metal oxides such as ITO. The counter electrode 19 is formed by sputtering, and patterned by wet etching or dry etching through a resist pattern formed by photolithography. The thickness of the counter electrode 19 is preferably 50 nm to 200 nm, and more preferably 60 nm to 120 nm.

Next, before formation of the second interlayer insulating film 20, treatment (hereinafter, also referred to as pretreatment) is performed on the insulating substrate 11 on which the counter electrode 19 is formed. The pretreatment may be plasma treatment. Thereby, the resist residue on the counter electrode 19 can be removed. The pretreatment can also roughen the surfaces of the counter electrode 19 and the organic insulating film 18. As a result, the adhesion between the counter electrode 19 and the second interlayer insulating film 20 and between the organic insulating film 18 and the second interlayer insulating film 20 can be enhanced. Also, since plasma has a strong influence particularly on the organic insulating film 18, the exposed portion of the organic insulating film 18 is removed by decomposition by the plasma. That is, the plasma treatment etches the organic insulating film 18 with the counter electrode 19 as a mask. As a result, the step portion 18a having a height of 20 nm or lower is formed as described above.

However, the overhanging portion as disclosed in Patent Literature 1 can be formed depending on the plasma treatment conditions, and it is therefore preferred to appropriately adjust the plasma treatment conditions. The plasma treatment may be performed by any device by any method. Examples of the device include a plasma CVD device, a plasma etching device, and plasma ashing device. In particular, the plasma treatment is preferably performed in the same device as the device for forming the second interlayer insulating film 20 (plasma CVD device is suitable). When a plasma CVD device is used, the organic insulating film 18 is considered to be etched (removed by decomposition) isotropically. However, since the height of the step portion 18a is set to 20 nm or lower in the present embodiment, formation of an overhanging portion can be prevented.

The amount of the organic insulating film 18 shaved increases as the plasma treatment time increases. The treatment time is thus preferably as short as possible. When a plasma CVD device for forming the second interlayer insulating film 20 is used, the temperature in the device is around 200°C which is higher than the ordinary temperature as described below. Hence, the plasma treatment is preferably started before the temperature of the insulating substrate 11 excessively increases after the insulating substrate 11 is placed in the plasma CVD device. The amount of the organic insulating film 18 shaved increases as the time before the start of treatment increases. Accordingly, the time for plasma treatment and the time before the start of plasma treatment are both preferably set to several seconds to tens of seconds.

The plasma treatment is preferably oxygen-based plasma treatment utilizing oxygen-based gases. Specific suitable examples of the oxygen-based gases include oxygen (O₂) and nitrous oxide (N₂O). N₂O gas can be used in the case of a plasma CVD device, and O₂ gas can be used in the case of a plasma etching device or a plasma ashing device. If the counter electrode 19 is formed using a metal oxide, the surface of the counter electrode 19 can be refined by oxygen-based plasma treatment, and oxygen deficiency on the surface can be repaired.

Next, on the insulating substrate 11 on which the pretreatment has been performed, the second interlayer insulating film 20 as an inorganic passivation film is formed. The material of the second interlayer insulating film 20 can be, for example, silicon nitride (SiNx) or silicon oxide (e.g. SiO₂). The second interlayer insulating film 20 is formed by the plasma CVD method, and patterned by wet etching or dry etching through a resist pattern formed by photolithography. As a result, openings are formed in the second interlayer insulating film. These openings are formed such that they at least partially overlap the contact holes, that is, the drain electrodes 16 are exposed in the openings. The second interlayer insulating film 20 may be a laminate film formed from the above materials.

The temperature for forming the second interlayer insulating film 20 is limited to the range that does not cause deterioration of the organic insulating film 18. Specifically, the temperature is preferably equal to or lower than the firing temperature for the organic insulating film 18. More specifically, the temperature is preferably 190°C to 230°C, more preferably 200°C to 220°C. Thus, since the second interlayer insulating film 20 is formed by what is called a low-temperature CVD method, a decrease in the cohesion (adhesion) between the second interlayer insulating film 20 and the counter electrode 19 and the organic insulating film 18, which are formed under the second interlayer insulating film 20, is concerned. However, since the above pretreatment has been performed before formation of the second interlayer insulating film 20, the cohesion (adhesion) can be sufficiently achieved. The present inventors have verified that in the present embodiment, an overhanging portion is not formed by the end portion 19a of the counter electrode 19, and that the above-described cohesion is sufficiently achieved.

Next, the pixel electrodes 21 are formed on the insulating substrate 11 on which the second interlayer insulating film 20 is formed. The material of the pixel electrodes 21 can be, for example, a transparent conductive material. Specific examples of the transparent conductive film material include metal oxides such as ITO. The pixel electrodes are formed by sputtering, and patterned by wet etching or dry etching through a resist pattern formed by photolithography.

As a result, an array substrate is completed. In the following cell assembling step, an alignment film is formed by application of an alignment film material containing an organic resin such as polyimide to the surfaces of the array substrate and the separately produced counter substrate. By a method such as rubbing treatment and photoalignment treatment, the respective alignment films are subjected to alignment treatment such that the liquid crystal molecules are aligned in a given direction.

Next, a sealing material is applied to one of the array substrate and the counter substrate, so that the display region is surrounded by the sealing material. On one of the array substrate and the counter substrate, a liquid crystal material is dropped. The array substrate and the counter substrate are then placed on the top of the other such that the alignment films on the respective substrates face one another. The sealing material is then cured to bond the substrates. Thereby, a liquid crystal layer is formed between the substrates.

Then, a liquid crystal panel is completed through the step of bonding the polarizing plate and optionally a phase plate. To the liquid crystal panel, an FPC substrate and (optionally) an IC chip on which a driving circuit is formed are connected, and the controller and the backlight unit are mounted on the liquid crystal panel. The liquid crystal panel is then housed in a case, whereby a liquid crystal display of Embodiment 1 is completed.

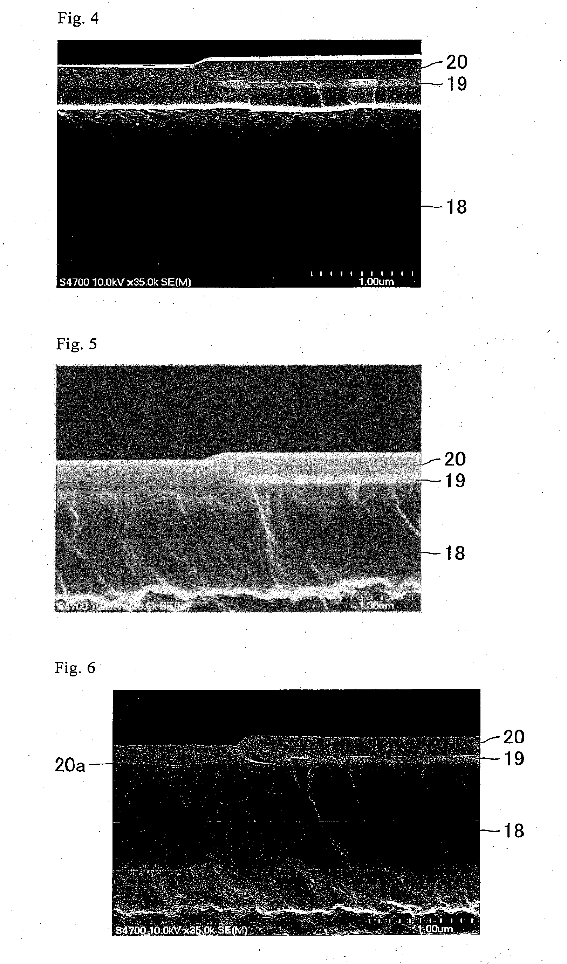

The following shows the results of studying the relation between the height h of the step portion 18a of the organic insulating film 18 and the coatability of the second interlayer insulating film 20. Figs. 4 to 8 are each an SEM photograph of a cross-section of the array substrate before formation of a counter electrode. Figs. 4 and 5 each illustrate the array substrate in the present embodiment. Figs. 6 to 8 each illustrate an array substrate in Comparative Embodiments 2 to 4.

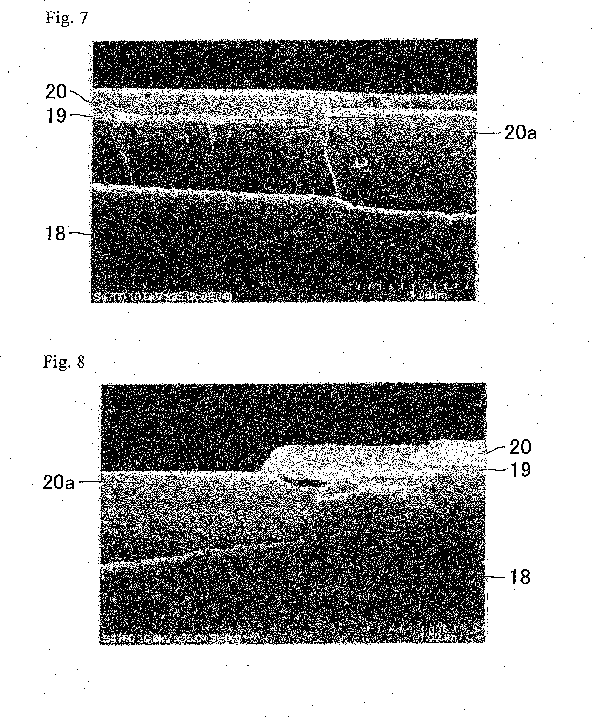

In each of these steps for producing an array substrate, oxygen-based plasma treatment was performed using a plasma CVD device for forming the second interlayer film 20 before formation of the second interlayer insulating film 20. The oxygen-based gas used was N₂O gas. The respective array substrates illustrated in Figs. 4 to 8 were produced in the same manner except that the time for plasma treatment, the time from placement of the array substrate in a plasma CVD device to the start of the plasma treatment (hereinafter, also referred to as time before the start of treatment), and the distance between the electrodes in the plasma CVD device were changed. For the array substrates illustrated in Figs. 5 to 8, the time for plasma treatment and/or the time before the start of treatment was/were prolonged compared to those for the array substrate illustrated in Fig. 4. The distance between the electrodes was 30 mm for the array substrate illustrated in Fig. 7, and was 25 mm for the array substrates illustrated in the drawings other than Fig. 7. For each of the array substrates illustrated in Figs. 4 to 8, the RF power was set to 57 mW/cm², and the process pressure was set to 1100 mTorr.

As a result, the height (the amount shaved) of the step portion of the organic insulating film 18 was 10 nm in the array substrate illustrated in Fig. 4, 20 nm in the array substrate illustrated in Fig. 5, 30 nm in the array substrate illustrated in Fig. 6, 100 nm in the array substrate illustrated in Fig. 7, and 180 nm in the array substrate illustrated in Fig. 8.

Also, the results show that when the height of the step portion (the amount of the organic insulating film 18 shaved) was 30 nm or higher, the coverage of the second interlayer insulating film 20 is insufficient, and fissures (cracks) 20a are generated, at portions around the step portions. Such fissures not only allow moisture to enter therethrough but also cause defects such as a decrease in the resist applicability and an alignment disorder of the liquid crystal molecules.

Meanwhile, the results show that when the height of the step portion was 20 nm or lower, favorable coverage without fissures can be achieved.

### (Embodiment 2)

The present embodiment is substantially the same as Embodiment 1 except that the structure around the end portions of the counter electrodes is different. Therefore, in the present embodiment, the features of the present embodiment are mainly described, and the features that are the same as those in Embodiment 1 are not described. Also, components (including the portions thereof) having the same or similar functions in the present embodiment and Embodiment 1 are provided with the same reference signs, and the components are not described in the present embodiment.

Fig. 9 is a schematic cross-sectional view of an array substrate included in the liquid crystal display of Embodiment 2, illustrating a TFT and the neighboring regions thereof in the display region.

The array substrate 10 included in the liquid crystal display of the present embodiment is provided with the insulating substrate 11, the TFTs 22 arranged on the insulating substrate 11, the first interlayer insulating film 17 arranged on the TFTs 22, the organic insulating film 18 arranged on the first interlayer insulating film 17, the counter electrode 19 arranged on the organic insulating film 18, the second interlayer insulating film 20 covering the organic insulating film 18 and the counter electrode 19, and the pixel electrodes 21 arranged on the second interlayer insulating film 20. The TFTs 22 each include the gate electrode 12, the gate insulating film 13, the semiconductor layer 14, the source electrode 15, and the drain electrode 16.

Also in the present embodiment, plasma treatment (preferably oxygen plasma treatment) is performed before formation of the second interlayer insulating film 20. The counter electrode 19 therefore has a plasma-treated surface. In the present embodiment, however, more mild plasma treatment is performed than in the case of Embodiment 1. Hence, the organic insulating film 18 is hardly etched by the plasma treatment. More specifically, it is preferred to shorten the time for plasma treatment and/or the time before the start of treatment compared to the case of Embodiment 1. When a plasma CVD device is used, the RF power, the process pressure, and the distance between electrodes can respectively be set to, for example, 42 mW/cm², 1100 mTorr, and 25 mm. As a result, the organic insulating film 18 does not have a step portion under the end portion 19a of the counter electrode 19, and has a flat upper surface 18b, as illustrated in Fig. 9.

The present embodiment can achieve the same effects as Embodiment 1.

As described above, in the structure in each of Embodiments 1 and 2, the pixel electrodes are arranged on the counter electrode with the second interlayer insulating film in between. In the structure in each of the embodiments, the counter electrode may be arranged on the pixel electrodes with the second interlayer insulating film in between. In this case, the pixel electrodes correspond to the above-described transparent electrode.

Also in Embodiments 1 and 2, what is called bottom-gate TFTs were described in which the gate electrodes were arranged between the insulating substrate and the semiconductor layers. In each of the embodiments, however, the TFTs may be of any type appropriately selected. For example, what is called planar TFTs may be used in which semiconductor layers are arranged between the insulating substrate and the gate electrodes, and the source electrodes and the drain electrodes are arranged on the gate electrodes with an interlayer insulating film in between.

The liquid crystal displays of the respective embodiments may be black and white liquid crystal displays. In this case, each of the pixels is not necessarily divided into subpixels.

In Embodiments 1 and 2, FFS-mode liquid crystal displays were described. The display mode for the liquid crystal displays of the respective embodiments may be any appropriate mode that utilizes an organic insulating film, a transparent electrode arranged on the organic insulating film, and an interlayer insulating film arranged on the transparent electrode. For example, the display mode may be a twisted nematic (TN) mode, a multi-domain vertical alignment (MVA) mode, an in-plane switching (IPS) mode utilizing the counter electrode and the pixel electrodes each having a comb structure and an interlayer insulating film arranged between the counter electrode and the pixel electrodes, or a transverse bend alignment (TBA) mode. In the TBA mode, the liquid crystal layer includes nematic liquid crystal molecules having a negative anisotropy of dielectric constant, the liquid crystal molecules are vertically aligned with no voltage applied, the array substrate includes a pair of electrodes (e.g. counter electrode and pixel electrodes each having a comb structure) and an interlayer insulating film arranged between the pair of electrodes, and the liquid crystal molecules are bend-aligned by the transverse electric field generated between the pair of electrodes. In particular, a suitable display mode for liquid crystal displays is a mode in which the array substrate includes a transparent electrode, transparent pixel electrodes, and an interlayer insulating film between the electrodes (hereinafter, such a structure is also referred to as a transparent Cs structure), and the retention capacitance is formed by these components. Examples of such display modes include continuous pinwheel alignment (CPA) mode which utilizes a transparent Cs structure. In the CPA mode utilizing a transparent Cs structure, the liquid crystal layer includes nematic liquid crystal molecules having a negative anisotropy of dielectric constant; the liquid crystal molecules are vertically aligned with no voltage applied, the array substrate includes a transparent electrode, an interlayer insulating film arranged on the transparent electrode, and transparent pixel electrodes arranged on the interlayer insulating film; common signals are supplied to the transparent electrode; the counter substrate includes a transparent electrode facing the pixel electrodes, and dot-like projections (rivets) arranged on the counter electrode; and the liquid crystal molecules are radially aligned with the rivets as the centers by the vertical electric field generated between the pixel electrodes and the counter electrode. Here, in place of forming dot-like projections (rivets), openings having a circular, cross, or polygonal shape, for example, may be formed on the counter electrode, so that the liquid crystal molecules can be radially aligned with the openings as the centers.

Also, in Embodiments 1 and 2, transparent liquid crystal displays have been described, but the liquid crystal panels of the respective liquid crystal displays may be provided with a reflecting display portion that provides display by reflecting external light.

The above embodiments may be appropriately combined as long as the combination does not go beyond the scope of the present invention. Also, the alternative examples of each embodiment can be combined with the other embodiments.

### REFERENCE SIGNS LIST

1: Liquid crystal panel
10: Array substrate
11: Insulating substrate
12: Gate electrode
13: Gate insulating film
14: Semiconductor layer
15: Source electrode
16: Drain electrode
17: First interlayer insulating film
18: Organic insulating film
18a: Step portion
18b: Upper surface
19: Counter electrode
19a: End portion
20: Second interlayer insulating film
20a: Fissure (crack)
21: Pixel electrode
21a: Slit
22: TFT
30: Liquid crystal layer
31, 32: Alignment film
40: Counter substrate
41: Insulating substrate
42: Color filter
43: Black matrix (BM)
44: Overcoat film
45: External conductive film
h: Height of step portion

## Claims

1. A liquid crystal display comprising:
an organic insulating film;
a transparent electrode arranged on the organic insulating film; and
an interlayer insulating film arranged on the transparent electrode,
the transparent electrode comprising a plasma-treated surface,
the organic insulating film being shaved vertically from an end portion of the transparent electrode, and thereby including a step portion under the end portion,
the transparent electrode not laterally protruding from the step portion,
the step portion having a height of 20 nm or lower.

2. The liquid crystal display according to claim 1,
wherein the step portion has a height lower than 10 nm.

3. The liquid crystal display according to claim 1 or 2,
wherein the transparent electrode is a counter electrode or a pixel electrode.

4. The liquid crystal display according to any one of claims 1 to 3, further comprising
a TFT comprising an oxide semiconductor under the organic insulating film.

5. The liquid crystal display according to claim 4,
wherein the oxide semiconductor contains indium, gallium, zinc, and oxygen.

6. A liquid crystal display comprising:
an organic insulating film;
a transparent electrode arranged on the organic insulating film; and
an interlayer insulation film arranged on the transparent electrode,
the transparent electrode comprising a plasma-treated surface,
the organic insulating film comprising a flat upper surface without a step portion under an end portion of the transparent electrode.
